# EUROPEAN PATENT SPECIFICATION

(11) **EP 1 591 755 B1**
(45) Date of publication and mention of the grant of the patent: **28.04.2010**
(21) Application number: 04010242.8
(22) Date of filing: 30.04.2004
(51) Int. Cl.: G01C 21/36, G06F 3/033

(54) **Car multimedia system and method for activating a function of such a system**
Fahrzeugmultimediasystem und -verfahren zur Aktivierung einer Funktion eines solchen Systems
Système multimédia embarqué et méthode pour activer une fonction d'un tel système

(43) Date of publication of application: 02.11.2005
(73) Proprietor: Harman Becker Automotive Systems GmbH, 76307 Karlsbad (DE)
(72) Inventor: Seeger, Isabell, 73773 Aichwald (DE)
(74) Representative: Bertsch, Florian Oliver

(56) References cited:
- DE-A- 19 747 284
- DE-A- 19 752 054
- FR-A- 2 738 196
- US-A- 5 270 689
- US-B1- 6 373 472

## Description

The present invention relates to a car multimedia system comprising a radio unit, a display for displaying a status information and selectable and activatable menu items, at least one control element for selecting and activating a menu item, and a control device for driving the display and controlling the control element. The present invention also relates to a method for selecting and activating a function of such a car multimedia system.

Car multimedia systems of the afore-mentioned kind are known. The applicant of the present invention, for example, offers a plurality of different types of car multimedia systems under the brand name "Becker". All of these systems have in common that they are designed to fit into standardized installation slots in the dashboard of a car. Because of these space requirements, the dimensions of a front panel of the car multimedia system are limited. Therefore, the front panel of the car multimedia system carries only a minimum number of selection keys, like hard keys and soft keys, one or two rotary push button switches and a display for displaying information and selection menus. The hard keys are assigned a predetermined function, whereas the soft keys are assigned variable functions to be selected.

Since car multimedia systems offer a plurality of different functions, including audio functions like radio or CD, navigation functions like route guidance, or telecommunication functions, like telephone, e-mail, SMS or WAP, a hierarchically structured menu system is provided and allows to select these functions by using some few hard keys, soft keys and/or the rotary push-button switch.

As generally known, a hierarchically structured menu system comprises a route menu item in a main menu level and a plurality of menu items in one or more sub-menu levels.

Due to the increasing number of functions offered by present car multimedia systems, the number of menu items as well as the number of sub-menu levels rapidly increases with the result that the user of the car multimedia system has to pass through many sub-menu levels as to reach the desired menu item. Hence, this selection takes more time than just to push a hard or soft key with the result that the user's attention is focused on the car multimedia system for a "relatively long period" rather than on the traffic. This may lead to dangerous situations.

DE 19752 054 A1 discloses a car multimedia system according to the preamble of claim 1

In view of the above it is an object of the present invention to provide a car multimedia system of the afore-mentioned kind which allows to select and activate functions in a fast way and allows to adapt the system to the user's needs

This object is solved by the car multimedia system as mentioned in claim 1.

Generally, the display of the car multimedia system displays two kinds of information, namely status information and menu items of the hierarchically structured menu. In the context of the present application, "status information" means all kind of information indicating a specific setting and/or condition of the car multimedia system. Contrary thereto, a menu item does not give the user an information about a setting or condition of the system but allows to select and activate a predetermined function, for example, to change a setting. Hence, a status information displayed on the display is, for example, the selected radio station, the frequency, the waveband, program type, traffic announcement, traffic message channel, mail icon, map scale, CD number, title number, GSM provider, etc., just to name some of the possible status informations.

The idea underlying the present invention is now to use the status information displayed on the display to perform a function assigned to the respective status information. In other words, the status information is made selectable and activatable like menu items.

The user then may readily change a setting or condition of the car multimedia system by simply operating the control element as to select and activate the shown status information. For example, if the status information is a mail icon indicating that a message was received, the user selects this mail icon and activates it by operating the control element. In response to this activation, the assigned function "display received message" is performed. I.e., the user may read the message on the display.

It is apparent that the advantage of this system is a simplification of the operation of the car multimedia system. Hence, the user has not to call the menu and to navigate through the respective menu levels as to reach the menu item "display received message".

In a preferred embodiment, said function is to switch on and off a mode assigned to said status information.

I.e. in other words that the user may toggle between on and off a setting of the car multimedia system by selecting and activating said status information. For example, if the status information is "traffic announcement", the user may switch on and off this setting, i.e. to select the setting "traffic announcement on" or "traffic announcement off".

This measure has the advantage that the user may change the respective setting fast and easily.

In a preferred embodiment said function is to jump into a menu assigned to said status information.

I.e. in other words that the function is not to toggle between two modes of a setting. Rather, the performed function is to call a menu so that the user may select and activate a menu item belonging to this menu. This function is always used in cases where the setting to be changed is more complex than just on and off. Preferably, the function is to display a list of selectable menu items. For example, if the status information is "waveband", a list of different items, namely UKW, MW, LW, is displayed. The user may then select one of these menu items as the radio waveband setting.

The advantage of this measure is that the ergonomics of the system is further improved.

In a preferred embodiment, said function is performed in response to a long activation of said status information.

I.e. in other words that the user operates the control element longer than the normal operation. The system differentiates between both activations (long or short activation) and performs the respective function.

The advantage of this measure is that two different functions may be assigned to one status information which may be activated by a short or long activation of the control element. Hence, the ergonomics of the system may further be improved.

According to the invention, said selector means is adapted to enable and disable a highlighting of a status information to indicate its selectability. Furthermore, said selector means disables said highlighting after lapse of a predetermined time period of non-operating said control element.

This means that the highlighting of a status information disappears, however, the respective status information remains selected. The user may then perform the function assigned to said selected status information by simply operating the control element without having to select it again.

This measure has the advantage that the user may perform a "preselection" of a status information and hence assign the control element a specific function. For example, the user may select the status information "traffic announcement" as a pre-selection. Since this status information remains selected, the user may switch on and off the traffic announcement by just one operation of the control element as long as this preselection is maintained.

In contrast to this preferred embodiment, the selection of a status information is cleared after lapse of a predetermined time period, and a default selection is made. In this embodiment, the user cannot make a pre-selection which is kept during operation of the car multimedia system. Rather, the user always has to reselect the respective status information after lapse of a predetermined time period of non-operating said control element.

As already mentioned before, the status information is at least one of radio station, waveband, frequency, program type, traffic announcement, traffic message channel, mail. Of course, it is apparent that this is not a complete list of possible status information. It is to be noted that the present invention is not limited to the mentioned status information.

The car multimedia system of the present invention comprises at least a radio unit. However, it preferably comprises also a navigation unit for performing route guidance and a telecommunications unit for providing telecommunications services, like telephone, e-mail, SMS, Internet, etc.

In a preferred embodiment, said status information is at least one of radio station, waveband, frequency, program type, traffic announcement, traffic message channel, mail. It is preferred that upon selection and activation of the status information "traffic announcement" or "traffic message channel", the respective function is switched on or off. Preferably, upon selection and activation of the status information "mail", the mail currently received is displayed.

It is further preferred that upon selection and activation of the status information "traffic message channel", the current traffic messages are displayed. Further, upon selection and activation of the status information "radio station", a list of radio stations is displayed for selection and activation.

Further features and advantages can be taken from the following description and the enclosed drawings.

It is to be understood that the features mentioned above and those yet to be explained below can be used not only in the respective combinations indicated, but also in other combinations or in isolation, without leaving the scope of the present invention.

An embodiment of the invention is shown in the drawings and will be explained in more detail in the description below with reference to same. In the drawings:
- Fig. 1: is a schematic front view of a car multimedia system;
- Fig. 2: is a schematic view of the display of the car multimedia system showing a status information screen;
- Fig. 3A: is a schematic view of the status information screen of Fig. 2 with one icon being highlighted;
- Fig. 3B: is a schematic view of an SMS message screen;
- Fig. 4A-D: are schematic views of a status information screen; and
- Fig. 5: is a schematic block diagram of the car multimedia system.

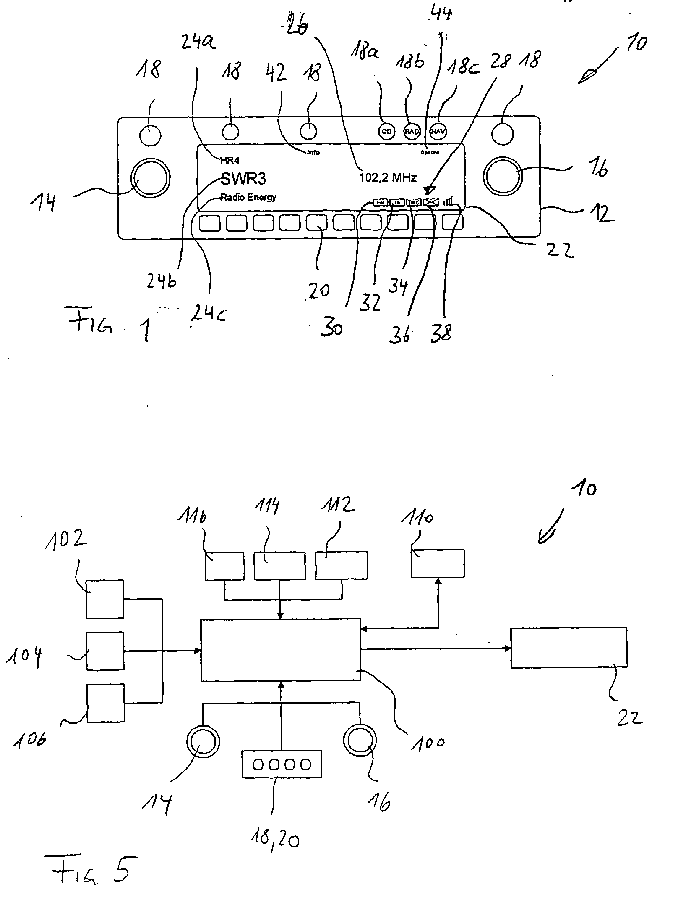

In Fig. 1, a front panel 12 of a car multimedia system 10 is schematically shown. The car multimedia system 10 is designed as a device which fits into the standardized installation slot in the dashboard of a vehicle. In addition to the device disposed in the dashboard, a further device is placed within the vehicle, for example in the glove compartment. This second device is the so-called GSM/GPS box offering navigation and telecommunication services. The GSM/GPS box is electrically connected with a device in the dashboard (both devices defining the car multimedia system 10).

Both devices have a plurality of connectors allowing to connect necessary hardware, like earphone, GSM antenna, GPS antenna, hand-free microphone, radio antenna, loudspeaker, etc. For the sake of simplicity, these parts are not shown in Fig. 1.

The car multimedia system offers a plurality of different functions and services, for example radio, navigation, telephone, e-mail, SMS, etc. All these functions and services may be selected by a user of the car multimedia system 10 via the front panel 12.

The front panel 12 comprises a first rotary push-button switch 14 which allows to control the volume by rotating the rotary push-button 14 and to switch on and off the car multimedia system 10 by pushing the switch 14. The rotary push-button switch 14 is placed on the left hand side of the front panel 12. On the right hand side, a second rotary push-button switch 16 is provided which allows to select a menu item by rotating and to activate it by pushing the rotary push-button switch 16.

Further selection keys in form of push-button switches 18 are provided in the upper front panel area. Three of these selection keys are referenced with reference numeral 18a, 18b and 18c. The selection keys 18 serve to select a predetermined function of the car multimedia system 10, in the present case the CD function with selection key 18a, the radio function with selection key 18b and the navigation function with selection key 18c. Generally, such selection keys provided for selecting one specific function are called "hard keys".

In addition to these hard keys, the front panel 12 also carries so-called soft keys 20. These soft keys 20 serve to select variable functions depending on the mode in which the car multimedia system is operated. In the present embodiment, ten soft keys are provided in the lower margin area of the front panel 12.

In the center of the front panel 12, a display 22 is disposed. In the present embodiment, the display 22 is a dot matrix display, which allows to display several lines of information in the form of characters, words or pictures, icons or pictograms. The displayed information is either status information or menu information in the form of menu items. In the context of the present application, status information is any information informing the user about a setting or condition of the car multimedia system 10. Such a status information is, for example, the selected waveband (UKW, MW, LW), the mode of traffic announcement (on, off), the selected program type, a mail icon informing about a received message, etc.

In contrast thereto, a menu information is any menu item belonging to the hierarchically structured menu system of the car multimedia system for operating its several functions.

In Fig. 1, the display 22 displays a screen containing status information and menu information. The shown screen is the standard screen during radio operation of the car multimedia system 10. Hence, some of the status information relates to settings of the radio unit of the car multimedia system 10.

In particular, the radio status screen contains three lines of radio station names 24a-c, which are part of a longer list containing all radio station names which are receivable by the radio unit. The name of the selected radio station 24b is displayed with a larger font as to differentiate it from the other radio station names which are not selected. The radio station names are displayed in the left margin area of the display 22. Further to the selected radio station name 24b, the respective frequency of this radio station is displayed and indicated with reference numeral 26 in Fig. 1.

In the lower right margin area of the display 22, further status information is shown as small icons 28. From left to right, the first icon 30 indicates the selected waveband (UKW, MW, LW or FM, AM). The next icon 32 relates to the traffic announcement mode (TA) and indicates whether the traffic announcement mode is switched on or off. For example, the letters "TA" are shown in a normal font when switched on and in an Italic font when switched off. The next icon 34 relates to the traffic message channel mode (TMC) indicating that the car multimedia system receives traffic messages which are, for example, considered by the navigation unit for route guidance. The next displayed icon 36 relates to a condition of the telecommunications unit, particularly the inbox of the SMS receiving unit. In other words, the letter or mail icon 36 indicates that the car multimedia system 10 has received an SMS message. If the inbox is, for example, empty, the icon 36 disappears from the display 22. The next icon 38 also relates to a condition of the telecommunications unit, particularly the GSM box. The icon 38 signalizes the received GSM signal strength.

The above-mentioned status information icons 30-38 are not only displayed on the radio status information screen as shown in Fig. 1, but are also part of other status information screens. For example, the icons 30-38 are shown on the navigation screen or a telecommunications screen. On the navigation screen, route guidance information or a map, for example, are displayed instead of the radio information. On the telecommunications screen, any information relating to telecommunications services is, for example, displayed. At this point it is to be noted that the status information screen shown in Fig. 1 displays main status information, like radio station name or radio frequency, which only belongs to this respective screen. In contrast thereto, the secondary status information, namely the status information icons 30-38, is also displayed on other status information screens, for example a navigation screen or a telecommunications screen. The secondary status information is hence a screen-comprehensive information. Further, at least some of the status information icons 30-38 do not directly relate to the main status information on the screen, namely radio station name and radio station frequency. Hence, the status information icons 30-38 indicate settings and modes of different functions or services of the car multimedia system 10.

In Fig. 1, the exemplary radio station information screen contains further status information indicated with reference numeral 42. This status information 42 is the program type selected by the user. The user may filter the list of receivable radio stations by a program type classifier, for example info, classic, pop, etc. In the present example, the selected program type is "info".

Finally, the radio status information screen shown in Fig. 1 contains one menu item indicated with reference numeral 44 and named "options". By selecting and activating this menu item 44, the user may jump to a menu for changing or adjusting settings or modes of the car multimedia system.

In prior solutions, the change or adjustment of settings or modes of the car multimedia system, for example to switch on and off the traffic announcement mode or to display traffic messages, was achieved by selecting and activating the respective menu items in the menu system. Hence, the user had to navigate through sub-menu levels in order to find the desired menu item; particularly, if the desired setting or mode did not relate to the main status information displayed on the screen. With respect to Fig. 1, the setting or mode "display message" which relates to telecommunications services and not to the radio function, is such a case.

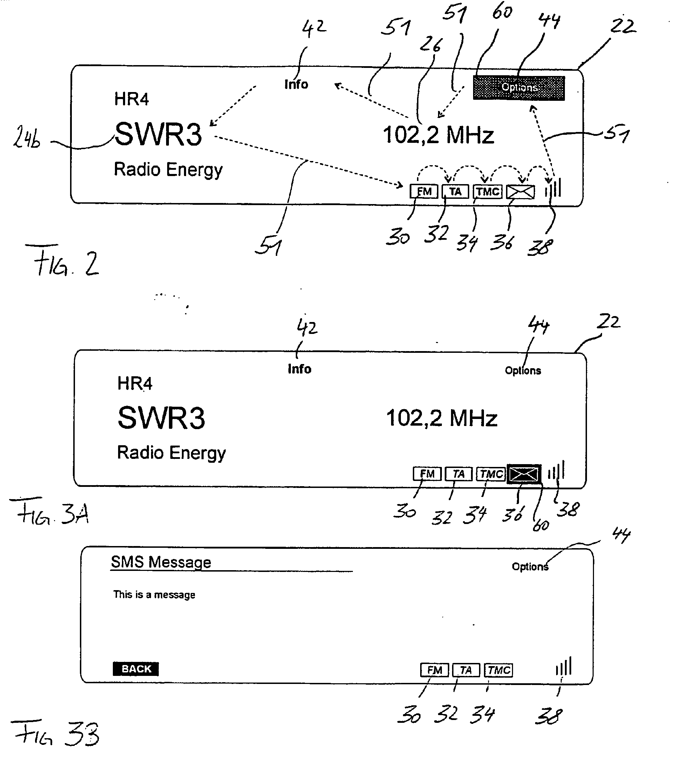

With respect to Figs. 2 - 4, the new concept is now described. Fig. 2 shows only the display of the car multimedia system 10 without the other parts of the front panel 12. The display 22 shows all status information and menu items as described with respect to Fig. 1. In addition, arrows in broken lines are drawn and indicated with reference numeral 51. Each arrow 51 connects one status information or menu item with an adjacent status information or menu item. In particular, one arrow connects the menu item 44 with the frequency information 26, which is in turn connected with the status information program type 42. This status information 42 is connected via an arrow 51 with the radio station name 24b which, in turn, is connected with the waveband icon 30. This icon is connected with the adjacent icon 32 which is connected with the next icon 34 and then the next icon 36 and, finally, the icon 38. An arrow 51 then points to the menu item 44. This chain of arrows, status information and menu items describes the order in which the status information and menu items are selectable. I.e. in other words that the car multimedia system 10 allows the user to move a selection mark (cursor) from one status information to the next according to the order indicated by the arrows and in response to an operation of the rotary push-button switch 16. With respect to Fig. 2, a selection mark is indicated with reference numeral 60 and is shown as a highlighting of the menu item "options" 44. The selection mark 60 may, hence, be moved from menu item 44 to status information 26, program type information 42, radio station name 24b, waveband icon 30, traffic announcement icon 32, traffic message channel 34, menu icon 36, signal strength icon 38 and then back to the menu item "options" 44. This movement of the selection mark 60 is achieved by rotating the rotary push-button switch 16 counterclockwise. Of course, upon rotation of the rotary push-button switch 16 in the clockwise direction, the order of selection is reversed.

Each selectable status information or menu item on the display 22 is assigned a predetermined function which may be performed (activated) by pushing the rotary push-button switch 16. The predetermined function is, for example, to switch on and off a setting or mode or to display a menu.

One example of such a function is now described with respect to Figs. 3a and 3b. In Fig. 3a, the mail icon 36 is highlighted. I.e. the user has moved the selection mark 60 on this icon 36 by turning the rotary push-button switch 16 clockwise or counterclockwise. To perform the function assigned to this icon 36, the user pushes the rotary push-button switch 16. As a result, the screen displayed on the display 22 is changed, as shown in Fig. 3b, and displays the received SMS message. Hence, the function assigned to the mail icon 36 is to display the received message. In prior approaches, the function "read message" was activated by navigating through a more or less complex menu structure. In contrast thereto, the present car multimedia system 10 allows to use the mail status information on the display to activate the "read message" function.

As it is apparent from Fig. 3b, the mail icon 36 has disappeared after its selection and activation. The reason is that the mail icon indicates only new unread messages. As soon as the "read message" function has been performed, the message is flagged as a read message. Hence, the mail icon 36 disappears.

Nevertheless, the remaining status information icons 30, 32, 34 and 38 are further displayed and may of course be selected by the user. In addition to these status information icons, a further menu icon "back" is displayed which allows to change back to the former screen, as shown in Fig. 3a. As an alternative, the car multimedia system 10 may also change to the former screen after a predetermined time period.

It is to be noted that the status information icons 30, 32, 34 and 38 shown on the screen of Fig. 3b may be selected in order to perform the respective assigned function in the same manner as described above with respect to the mail icon 36.

For example, if the icon 30 is selected and activated, the car multimedia system 10 displays a list of different wavebands the user may choose. Such a list may, for example, comprise (in Germany) UKW, MW or LW (Ultrakurzwelle, Mittelwelle, Langwelle). By operating the rotary push-button switch 16, the user may then select the desired waveband.

If the user selects and activates the traffic announcement icon 32, he may toggle between traffic announcement on and traffic announcement off mode. Referring to Figs. 2 and 3, the traffic announcement on mode is displayed in bold characters TA, and the traffic announcement off mode is indicated by Italic characters TA.

If the user, for example, selects and activates the TMC icon 34, the received and stored traffic messages are displayed on the display 22 quite similar to the display of the SMS message, as shown in Fig. 3b.

If the user selects and activates the signal strength icon 38, a predetermined screen for allowing the input of a telephone number, for example, is displayed.

However, it is to be noted that the described examples of functions assigned to the status information icons are mere illustrative rather than limiting the invention. I.e., a man skilled in the art knows that other functions may be assigned to these icons as well.

To further increase the flexibility of the system, it is possible to assign each status information icon two functions which are distinguished by different operations of the rotary push-button switch 16. In particular, one function may be performed upon a short operation of the rotary push-button switch, and the second function may be performed upon a long operation of the rotary push-button switch. A short operation means pushing the rotary push-button switch only for a short time period, and a long operation means to push the respective switch for a longer time period.

For example, with respect to the TA icon 32, the first function is to toggle between the on and off mode, and the second function is to call a respective menu which allows to change all settings relating to the traffic announcement mode, like volume of the traffic announcement, radio station, etc.

It is apparent that each status information icon displayed may be assigned one or two functions.

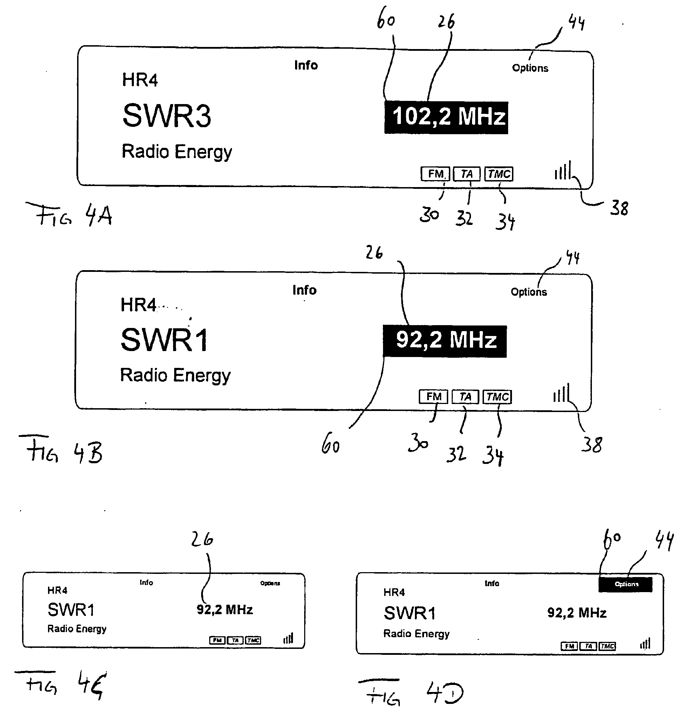

With respect to Figs. 4A-D, another selection of a status information will be described. As it is shown in Fig. 4A, the selector mark 60 has been moved by the user to the frequency information 26. If the user now activates the function assigned to the frequency information 26 by pushing the rotary push-button switch, the user is then allowed to change the frequency of the radio by turning the rotary push-button switch 16. With respect to Figs. 4A and B, the user has changed the frequency from 102.2 MHz to 92.2 MHz. Hence, the function assigned to the frequency status information 26 is to call an editing mode for the frequency.

A second function assigned to the frequency status information 26 and being activatable by a long operation of the respective switch 16 is, for example, to start a search for a radio station with the highest signal strength. However, other functions are also possible. For example, a first function may be to call a menu which allows to adjust the pitch of the manual adjustment of the frequency (first function).

After having done the selection and activation to perform the desired function, there are two alternatives how the car multimedia system proceeds further. According to a first alternative, shown in Fig. 4C, the selection mark 16 disappears. However, the frequency status information 26 remains selected and activated. This allows the user to easily change the frequency even at a later time just by turning the rotary push-button switch 16. In other words, this alternative is like a programming of the rotary push-button switch 16.

According to a second alternative, the selection mark 60 moves back to a default menu item after lapse of a predetermined time period within which no operation of the rotary push-button switch 16 was performed. In the present embodiment, the selection mark 60 moves back to the menu item "options" 44. This alternative is illustrated in Fig. 4B.

To sum up, the car multimedia system 10 allows to select status information displayed on a status information screen and to perform a function assigned to the respective status information. This function may be either to switch on and off a respective mode or to enter an edit mode which allows more complex settings.

With respect to Fig. 5, the structure of the car multimedia system 10 is described. The car multimedia system 10 comprises a central controller 100 which is adapted to control all functions and services of the system. The controller 100 is connected with a radio unit 102 comprising, for example, a radio tuner, an antenna, etc. The controller 100 is also connected with a navigation unit 104 comprising all components necessary for route guidance. Finally, a telecommunications unit 106 is provided which comprises all components necessary for telephone, Internet, SMS, etc.

The controller 100 is also connected with control elements like the rotary push-button switches 14 and 16 and the push-button switches 18, 20. The central controller 100 drives the display 22.

The car multimedia system 10 further comprises a selector device 110 which is adapted to make the status information on a displayed screen selectable as described in detail above. This selector device 110 communicates with the central controller 100 and cooperates with a performing device 112 which is adapted to perform the function assigned to a status information in response to the activation of this status information. Hence, the performing device may be provided as a memory storing the respective program code necessary for performing the function. However, the program itself runs in the central controller 100.

The car multimedia system 10 further comprises a program memory 114 and a random access memory 116 which allows to write and read data arbitrarily.

It is to be noted that the block diagram shown in Fig. 5 illustrates functional units of the car multimedia system 10. It is apparent for a man skilled in the art that any functional units may be combined in one hardware unit, for example. This means that the performing device 112 and the selector device 110 may be part of the controller 100. It is also apparent that the selector device 110 may be provided as hardware or software.

Those skilled in the art can now appreciate from the foregoing description that the broad teachings of the present invention can be implemented in a variety of forms. Therefore, while this invention has been described in connection with a particular example thereof, the true scope of the invention should not be so limited since other modifications will become apparent to the skilled practitioner upon a study of the drawings, specification and the claims.

## Claims

1. Car multimedia system comprising
- a radio unit (102);
- a display (22) for displaying status information (24, 26, 28) and selectable and activatable menu items (44);
- at least one control element (16) for selecting and activating a menu item (44);
- a control device (100) connected to said control element (16) for driving said display (22);
- selector means (110) for making a status information (24, 26, 28) on the display selectable and activatable by operating said control element (16);
- performing means (112) for performing a function in response to the activation of a status information (24, 26, 28),
wherein said selector means (110) is adapted to enable and disable a highlighting (60) of a status information (24, 26, 28) to indicate its selectability,
**characterized in that** said selector means (110) disables said highlighting (60) after lapse of a predetermined time period of non-operating said control element (16), the respective status information remaining selected and activated.

2. Car multimedia system of claim 1, **characterized in that** said function is to switch on and off a mode assigned to said status information (24, 26, 28).

3. Car multimedia system of claim 1 or 2, **characterized in that** said function is to jump into a menu assigned to said status information (24, 26, 28).

4. Car multimedia system of claim 3, **characterized in that** said function is performed in response to a long activation of said status information (24, 26, 28).

5. Car multimedia system of any of the preceding claims,
**characterized in that** said status information (28, 30-38) is at least one of radio station, waveband, frequency, program type, traffic announcement, traffic message channel, mail.

6. Car multimedia system of any of the preceding claims,
**characterized by** a navigation unit (104) and/or a telecommunication unit (106).

## Patentansprüche

1. Fahrzeug-Multimedia-System, umfassend
- eine Funkeinheit (102);
- eine Anzeige (22), um eine Statusinformation (24, 26, 28) und auswählbare und aktivierbare Menüelemente (44) anzuzeigen;
- mindestens ein Steuerelement (16), um ein Menüelement (44) auszuwählen und zu aktivieren;
- eine Steuervorrichtung (100), welche mit dem Steuerelement (16) verbunden ist, um die Anzeige (92) zu steuern;
- Auswahlmittel (110), um eine Statusinformation (24, 26, 28) durch eine Bedienung des Steuerelements (16) auf der Anzeige auswählbar und aktivierbar zu machen;
- Ausführungsmittel (112), um eine Funktion abhängig von der Aktivierung einer Statusinformation (24, 26, 28) auszuführen,
wobei die Auswahlmittel (110) derart ausgestaltet sind, dass sie ein Hervorheben (60) einer Statusinformation (24, 26, 28) aktivieren und deaktivieren, um seine Ausführbarkeit anzuzeigen,
**dadurch gekennzeichnet,**
**dass** die Auswahlmittel (110) das Hervorheben (60) nach Ablauf einer vorbestimmten Zeitperiode ohne Bedienung des Steuerelements (16) deaktivieren, wobei die entsprechende Statusinformation ausgewählt und aktiviert bleibt.

2. Fahrzeug-Multimedia-System nach Anspruch 1,
**dadurch gekennzeichnet,**
**dass** die Funktion darin besteht, eine Betriebsart, welche der Statusinformation (24, 26, 28) zugeordnet ist, ein- und auszuschalten.

3. Fahrzeug-Multimedia-System nach Anspruch 1 oder 2,
**dadurch gekennzeichnet,**
**dass** die Funktion darin besteht, in ein Menü zu springen, welches der Statusinformation (24, 26, 28) zugeordnet ist.

4. Fahrzeug-Multimedia-System nach Anspruch 3,
**dadurch gekennzeichnet,**
**dass** die Funktion abhängig von einer langen Aktivierung der Statusinformation (24, 26, 28) durchgeführt wird.

5. Fahrzeug-Multimedia-System nach einem der vorhergehenden Ansprüche,
**dadurch gekennzeichnet,**
**dass** die Statusinformation (28, 30-38) zumindest eine aus einer Funkstation, einem Frequenzband, einer Frequenz, einem Programmtyp, einer Verkehrsnachricht, einem Verkehrsnachrichtenkanal, einer Mail ist.

6. Fahrzeug-Multimedia-System nach einem der vorhergehenden Ansprüche,
**gekennzeichnet durch**
eine Navigationseinheit (104) und/oder eine Telekommunikationseinheit (106).

## Revendications

1. Système multimédia embarqué comprenant
- un bloc radio (102);
- un afficheur (22) pour afficher une information d'état (24, 26, 28) et des éléments de menu sélectionnables et activables (44);
- au moins un organe de contrôle (16) pour sélectionner et activer un élément de menu (44);
- un dispositif de contrôle (100) relié audit organe de contrôle (16) pour piloter ledit affichage (22);
- un moyen de sélection (110) pour rendre sélectionnable et activable une information d'état (24, 26, 28) sur l'afficheur par actionnement dudit organe de contrôle (16);
- un moyen d'exécution (112) pour exécuter une fonction en réponse à l'activation d'une information d'état (24, 26, 28), ledit moyen de sélection (110) étant adapté pour mettre en service et mettre hors service une mise en évidence (60) d'une information d'état (24, 26, 28) pour indiquer son sélectionnabilité,
**caractérisé en ce que** ledit moyen de sélection (110) met hors service la mise en évidence (60) après expiration d'une période de temps prédéterminée de non-actionnement dudit organe de contrôle (16), l'information d'état respective restant sélectionnée et activée.

2. Système multimédia embarqué selon la revendication 1, **caractérisé en ce que** ladite fonction consiste en la mise en marche et l'arrêt d'un mode affecté à ladite information d'état (24, 26, 28).

3. Système multimédia embarqué selon la revendication 1 ou 2, **caractérisé en ce que** ladite fonction est de sauter dans un menu affecté à ladite information d'état (24, 26, 28).

4. Système multimédia embarqué selon la revendication 3, **caractérisé en ce que** ladite fonction est exécutée en réponse à une activation de longue durée de ladite information d'état (24, 26, 28).

5. Système multimédia embarqué selon l'une quelconque des revendications précédentes, **caractérisé en ce que** ladite information d'état (28, 30-38) est au moins une information sur une station radio, une gamme d'ondes, une fréquence, un type de programme, un flash d'information routière, une voie de messages sur la circulation routière, un mail.

6. Système multimédia embarqué selon l'une quelconque des revendications précédentes, **caractérisé par** une unité de navigation (104) et/ou une unité de télécommunication (106).
